# EUROPEAN PATENT APPLICATION

(11) **EP 4 632 817 A1**
(43) Date of publication of application: **15.10.2025**
(21) Application number: 22967789.3
(22) Date of filing: 06.12.2022
(51) Int. Cl.: H01L 27/04

(54) **ESD PROTECTION DIODE AND STRUCTURE THEREOF**

(71) Applicant: Nisshinbo Micro Devices Inc., Tokyo 103-8456 (JP)
(72) Inventor: NAKAGAWA, Mario, Tokyo 103-8456 (JP); HASHIGAMI, Hiroyuki, Tokyo 103-8456 (JP)
(74) Representative: SSM Sandmair
(86) International application number: PCT/JP2022/044924
(87) International publication number: WO 2024/121936

(57) **Abstract**

An ESD protection diode includes two pairs of PN diodes in a semiconductor substrate (10), the two pairs of PN diodes being respectively formed of P-type and N-type diffusion layers (23, 24; 31, 32). The ESD protection diode includes a lateral bipolar transistor disposed between the two pairs of PN diodes in the semiconductor substrate, and the lateral transistor includes an P-type diffusion layer (25) having a polarity different from that of each terminal connected to an anode electrode (1), and the P-type and N-type diffusion layers (23, 24; 31, 32) The lateral bipolar transistor includes the first and second P-type diffusion layers (23, 24) connected to the anode electrode (1), the third P-type diffusion layers (25) formed between the first and second P-type diffusion layers (23, 24) and connected to a cathode electrode (2), and the first and second N-type diffusion layers (31, 32) formed in an N-type well (11) in the semiconductor substrate (10).

## Description

### TECHNICAL FIELD

The present invention relates to an electro static discharge (ESD) protection diode and a structure of the ESD protection diode.

### BACKGROUND ART

For example, Patent Document 1 discloses a diode having the following configuration, including a gate diode and a shallow trench isolation (STI) diode. The diode does not have at least one halo implant or pocket implant, which reduces the capacitance of the diode. This diode of a conventional example can obtain the performance characteristics of the diode while being used in circuits and other devices having performance that is sensitive to load capacitance. Such characteristics with respect to a gate diode include fast turn-on time and high conductance, making the gate diode suitable for an ESD protection circuit, for example. The diode includes a semiconductor substrate having a well region and an insulating layer thereon. A gate electrode is formed on the insulating layer. An anode region and a cathode region are provided in the well region.

That is, to protect a gate oxide film from overvoltage caused by an ESD surge (in particular, a charged device model (CDM)), the diode of the conventional example has a configuration in which a low-capacity gate diode having excellent conductance per unit length and turn-on speed, with the low-capacity gate diode not adversely affecting performance of a circuit to be protected. In addition, Patent Document 1 discloses a method for reducing junction capacitance, resulting in a problem unique to a gate diode.

### PRIOR ART DOCUMENT

### PATENT DOCUMENT

Patent Document 1: Japanese Patent Laid-open Publication No. JP2016-129267A

### SUMMARY OF THE INVENTION

### PROBLEMS TO BE SOLVED BY THE INVENTION

However, the diode of the conventional example takes a measure of blocking a pocket implant with a pocket implant mask to reduce the junction capacitance in the diode, and it is considered that the existing process flow needs to be changed for the technical application. In addition, the use of the gate diode has caused a problem of load capacitance.

An ESD protection element such as an ESD protection diode needs to be appropriately disposed according to specifications and withstand voltages of respective terminals, and the protection element itself is required to discharge at a voltage higher than an operating voltage of an internal circuit and lower than a breakdown voltage of the internal circuit. At the time of surge intrusion, the ESD protection diode plays a role of causing the protection element itself to discharge and clamp the surge after reaching a forward voltage Vf. However, there is a concern that gate oxide film breakdown may occur in each of the ESD protection diodes for low withstand voltage and high withstand voltage. In the ESD protection diode for low withstand voltage, an overshoot voltage generated until the protection diode reaches the forward voltage Vf becomes a problem because the gate oxide film of the element to be protected is thin.

On the other hand, in the ESD protection diode for high withstand voltage, the gate oxide film is thick, but the well concentration is low for securing the withstand voltage of the device. Thus, there is such a problem that the resistance component is high and the responsiveness of the protection diode is poor.

An object of the present invention is to provide an ESD protection diode with improved responsiveness of the protection diode as compared with that of the prior art, and a structure of the ESD protection diode.

### SOLUTIONS TO THE PROBLEMS

According to one aspect of the present invention, there is provided an ESD protection diode including two pairs of PN diodes in a semiconductor substrate, where each of the two pairs of PN includes a P-type diffusion layer and an N-type diffusion layer. The ESD protection diode further includes a lateral bipolar transistor at a position of the semiconductor substrate sandwiched between the two pairs of PN diodes. The lateral bipolar transistor includes: a diffusion layer connected to a cathode electrode or an anode electrode of the ESD protection diode, the diffusion layer having a polarity different from a polarity of the cathode electrode or the anode electrode; the P-type diffusion layer; and the N-type diffusion layer.

In the above-mentioned ESD protection, the two pairs of PN diodes include: a first PN diode including a first P-type diffusion layer and a first N-type diffusion layer; and a second PN diode including a second P-type diffusion layer and a second N-type diffusion layer. The lateral bipolar transistor includes: the first and second P-type diffusion layers connected to the anode electrode; a third P-type diffusion layer formed at a position between the first and second P-type diffusion layers and connected to the cathode electrode; and the first and second N-type diffusion layers formed in an N-type well in the semiconductor substrate.

Further, in the above-mentioned ESD protection diode, the two pairs of PN diodes include: a first PN diode including a first P-type diffusion layer and a first N-type diffusion layer, and a second PN diode including a second P-type diffusion layer and a second N-type diffusion layer. The lateral bipolar transistor includes: the first and second N-type diffusion layers connected to the cathode electrode, a third N-type diffusion layer formed at a position between the first and second N-type diffusion layers, the third N-type diffusion layer being connected to the anode electrode, and the first and second P-type diffusion layers formed in a P-type well in the semiconductor substrate.

### EFFECTS OF THE INVENTION

Therefore, the ESD protection diode according to an aspect of the present invention can provide an ESD protection diode or the like with improved responsiveness of the protection diode as compared with that of the prior art.

### BRIEF DESCRIPTION OF THE DRAWINGS

[Fig. 1] Fig. 1 is a longitudinal sectional view illustrating a configuration example of an ESD protection diode 101A according to a first embodiment.
[Fig. 2] Fig. 2 is a longitudinal sectional view illustrating a configuration example of a high withstand voltage ESD protection diode 102A according to a second embodiment.
[Fig. 3] Fig. 3 is a longitudinal sectional view illustrating a configuration example of an ESD protection diode 103A according to a third embodiment.
[Fig. 4] Fig. 4 is a longitudinal sectional view illustrating a configuration example of a high withstand voltage ESD protection diode 104A according to a fourth embodiment.
[Fig. 5] Fig. 5 is a graph illustrating a voltage ratio with respect to CDM which is a JEITA-standard DI-CDM test result of a conventional example and the ESD protection diode 101A according to the first embodiment mounted in a QFN0808-type package manufactured by the applicant according to Implementation Example 1.
[Fig. 6] Fig. 6 is a graph illustrating a voltage ratio with respect to CDM which is a JEDEC-standard FI(Field-Induced)-CDM test result of a conventional example and the ESD protection diode 101A according to the first embodiment mounted in a QFN0808-type package manufactured by the applicant according to Implementation Example 2.
[Fig. 7] Fig. 7 is a graph illustrating a voltage ratio with respect to CDM which is a JEDEC-standard FI(Field-Induced)-CDM test result of a conventional example and the ESD protection diode 101A according to the first embodiment mounted in an HSOP18-type package manufactured by the applicant according to Implementation Example 3.
[Fig. 8] Fig. 8 is a circuit diagram illustrating a configuration of a protection circuit using ESD protection diodes D1 and D2 according to the prior art.
[Fig. 9] Fig. 9 is a longitudinal sectional view illustrating a configuration of an ESD protection diode 101 according to Conventional Example 1.
[Fig. 10] Fig. 10 is a longitudinal sectional view illustrating a configuration of a high withstand voltage ESD protection diode 102 according to Conventional Example 2.
[Fig. 11] Fig. 11 is a longitudinal sectional view illustrating a configuration of an ESD protection diode 103 according to Conventional Example 3.
[Fig. 12] Fig. 12 is a longitudinal sectional view illustrating a configuration of a high withstand voltage ESD protection diode 104 according to Conventional Example 4.

### DETAILED DESCRIPTION

Hereinafter, embodiments according to the present invention will be described with reference to the drawings. Substantially the same members in the drawings are denoted by the same reference numerals.

### KNOWLEDGE OF INVENTOR ACCORDING TO CONVENTIONAL EXAMPLE

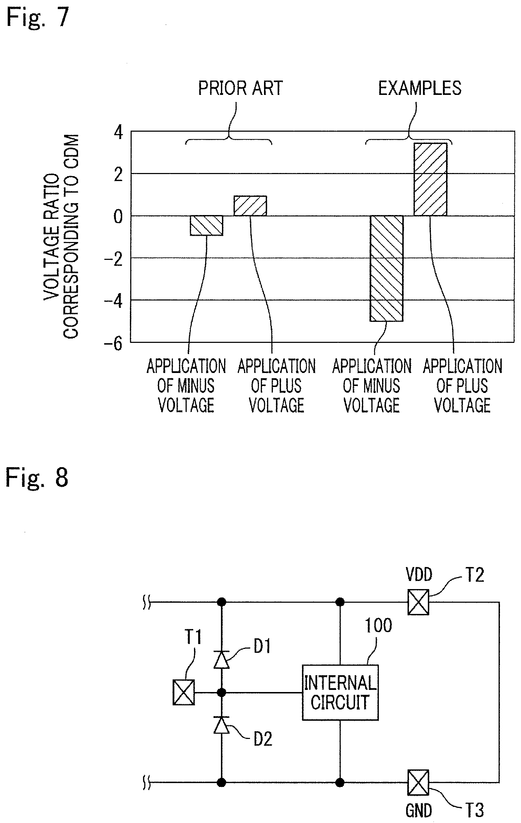

Fig. 8 is a circuit diagram illustrating a configuration of a protection circuit using ESD protection diodes D1 and D2 according to the prior art. As illustrated in Fig. 8, the ESD protection diodes D1 and D2 are inserted in both directions between an input pin terminal T1 and a VDD terminal T2 and between the input pin terminal T1 and a GND terminal T3. In this case, when a predetermined ESD surge voltage is applied between the terminals T1 and T2 or between the terminals T1 and T3, and a voltage equal to or higher than a forward voltage Vf is applied between the terminals between the anode and the cathode of the ESD protection diodes D1 and D2, the PN junction diodes of the ESD protection diodes D1 and D2 are turned on in the forward direction. The ESD surge current passes through the ESD protection diodes D1 and D2, which protects an internal circuit 100. In this case, the ESD protection diode D2 operates when a negative ESD surge voltage lower than a power supply voltage VDD is applied thereto, and the ESD protection diode D1 operates when a positive ESD surge voltage higher than the power supply voltage VDD is applied.

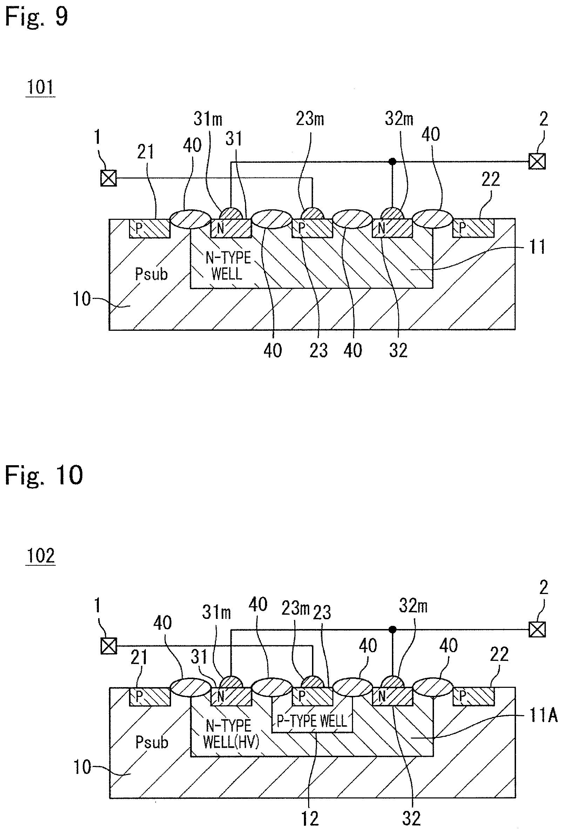

Next, the configurations of ESD protection diodes 101 to 104 according to Conventional Examples 1 to 4 will be described below with reference to Figs. 9 to 12.

Fig. 9 is a longitudinal sectional view illustrating a configuration of the ESD protection diode 101 according to Conventional Example 1.

Referring to Fig. 9, N-type impurity ions (for example, P or As with a dose amount of, for example, 2 x 10¹² to 1 x 10¹³ ions/cm²) are injected into a central portion of a P-type semiconductor substrate 10 to form an N-type well 11. Next, P-type impurity ions (for example, B with a dose amount of, for example, 1 x 10¹⁵ to 5 x 10¹⁵ ions/cm²) are injected into the P-type semiconductor substrate 10 on both outer sides of the N-type well 11 to form P-type diffusion layers 21 and 22, respectively. In addition, N-type impurity ions (for example, P or As with a dose amount of, for example, 1 x 10¹⁵ to 7 x 10¹⁵ ions/cm²) are injected into the N-type well 11 near the P-type diffusion layers 21 and 22 to form N-type diffusion layers 31 and 32, respectively. Then, P-type impurity ions (for example, B with a dose amount of, for example, 1 x 10¹⁵ to 5 x 10¹⁵ ions/cm²) are injected into the N-type well 11 between the N-type diffusion layers 31 and 32 to form a P-type diffusion layer 23. This apposes the P-type diffusion layer 21, the N-type diffusion layer 31, the P-type diffusion layer 23, the N-type diffusion layer 32, and the P-type diffusion layer 22 from the left side in the figure, near the substrate surfaces of the P-type semiconductor substrate 10 and the N-type well 11.

Next, an insulating film 40 made of, for example, SiO₂, is formed between the P-type diffusion layer 21 and the N-type diffusion layer 31, between the N-type diffusion layer 31 and the P-type diffusion layer 23, between the P-type diffusion layer 23 and the N-type diffusion layer 32, and between the N-type diffusion layer 32 and the P-type diffusion layer 22 near the substrate surface. Further, bonding wires connect the P-type diffusion layer 23 to an anode electrode 1 via an electrode 23m. In addition, bonding wires connect the N-type diffusion layers 31 and 32 to a cathode electrode 2 via electrodes 31m and 32m, respectively. Through the above steps, the ESD protection diode 101 is formed.

Fig. 10 is a longitudinal sectional view illustrating a configuration of a high withstand voltage ESD protection diode 102 according to Conventional Example 2.

Referring to Fig. 10, N-type impurity ions (for example, P or As with a dose amount of, for example, 5 x 10¹² to 1 x 10¹³ ions/cm²) are injected into a central portion of a P-type semiconductor substrate 10 to form a high withstand voltage N-type well 11A. Next, P-type impurity ions (for example, B with a dose amount of, for example, 1 x 10¹⁵ to 5 x 10¹⁵ ions/cm²) are injected into the P-type semiconductor substrate 10 on both outer sides of the high withstand voltage N-type well 11A to form P-type diffusion layers 21 and 22, respectively. In addition, N-type impurity ions (for example, P or As with a dose amount of, for example, 1 x 10¹⁵ to 7 x 10¹⁵ ions/cm²) are injected into the N-type well 11 near the P-type diffusion layers 21 and 22 to form N-type diffusion layers 31 and 32, respectively. Then, P-type impurity ions (for example, B with a dose amount of, for example, 1 x 10¹³ to 5 x 10¹³ ions/cm²) are injected into the high withstand voltage N-type well 11A between the N-type diffusion layers 31 and 32 to form a P-type well 12. Then, P-type impurity ions (for example, B with a dose amount of, for example, 1 x 10¹⁵ to 5 x 10¹⁵ ions/cm²) are injected into the P-type well 12 to form a P-type diffusion layer 23. This apposes the P-type diffusion layer 21, the N-type diffusion layer 31, the P-type diffusion layer 23, the N-type diffusion layer 32, and the P-type diffusion layer 22 from the left side in the figure, near the substrate surfaces of the P-type semiconductor substrate 10, the high withstand voltage N-type well 11A, and the P-type well 12.

Next, an insulating film 40 made of, for example, SiO₂, is formed between the P-type diffusion layer 21 and the N-type diffusion layer 31, between the N-type diffusion layer 31 and the P-type diffusion layer 23, between the P-type diffusion layer 23 and the N-type diffusion layer 32, and between the N-type diffusion layer 32 and the P-type diffusion layer 22 near the substrate surface. Further, bonding wires connect the P-type diffusion layer 23 to an anode electrode 1 via an electrode 23m. In addition, bonding wires connect the N-type diffusion layers 31 and 32 to a cathode electrode 2 via electrodes 31m and 32m, respectively. Through the above steps, the high withstand voltage ESD protection diode 102 having a higher withstand voltage than the ESD protection diode 101 of Fig. 8 is formed.

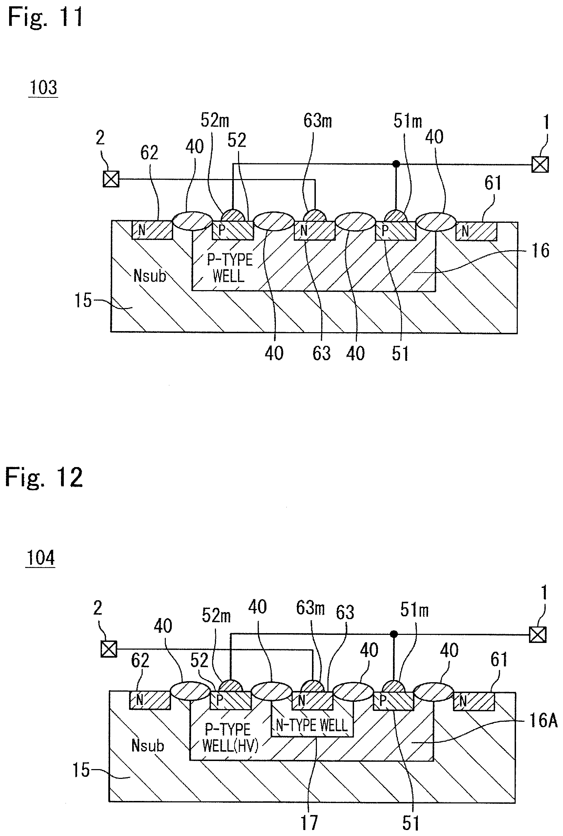

Fig. 11 is a longitudinal sectional view illustrating a configuration of the ESD protection diode 103 according to Conventional Example 3.

Referring to Fig. 11, P-type impurity ions (for example, B with a dose amount of, for example, 1 x 10¹³ to 5 x 10¹³ ions/cm²) are injected into a central portion of an N-type semiconductor substrate 15 to form a P-type well 16. Next, N-type impurity ions (for example, P or As with a dose amount of, for example, 1 x 10¹⁵ to 7 x 10¹⁵ ions/cm²) are injected into the N-type semiconductor substrate 15 on both outer sides of the P-type well 16 to form N-type diffusion layers 61 and 62, respectively. In addition, P-type impurity ions (for example, B with a dose amount of, for example, 1 x 10¹³ to 5 x 10¹³ ions/cm²) are injected into the P-type well 16 near the N-type diffusion layers 61 and 62 to form P-type diffusion layers 51 and 52, respectively. Then, N-type impurity ions (for example, P or As with a dose amount of, for example, 1 x 10¹⁵ to 7 x 10¹⁵ ions/cm²) are injected into the P-type well 16 between the P-type diffusion layers 51 and 52 to form an N-type diffusion layer 63. This apposes the N-type diffusion layer 61, the P-type diffusion layer 51, the N-type diffusion layer 63, the P-type diffusion layer 52, and the N-type diffusion layer 62 from the right side in the figure, near the substrate surfaces of the N-type semiconductor substrate 15 and the P-type well 16.

Next, an insulating film 40 made of, for example, SiO₂, is formed between the N-type diffusion layer 61 and the P-type diffusion layer 51, between the P-type diffusion layer 51 and the N-type diffusion layer 63, between the N-type diffusion layer 63 and the P-type diffusion layer 52, and between the P-type diffusion layer 52 and the N-type diffusion layer 62 near the substrate surface. Further, bonding wires connect the P-type diffusion layers 51 and 52 to an anode electrode 1 via electrodes 51m and 52m, respectively. In addition, bonding wires connect the N-type diffusion layer 63 to a cathode electrode 2 via an electrode 63m. Through the above steps, the ESD protection diode 103 is formed.

Fig. 12 is a longitudinal sectional view illustrating a configuration of a high withstand voltage ESD protection diode 104 according to Conventional Example 4.

Referring to Fig. 12, P-type impurity ions (for example, B with a dose amount of, for example, 2 x 10¹³ to 1 x 10¹⁴ ions/cm²) are injected into a central portion of an N-type semiconductor substrate 15 to form a high withstand voltage P-type well 16A. Next, N-type impurity ions (for example, P or As with a dose amount of, for example, 1 x 10¹⁵ to 5 x 10¹⁵ ions/cm²) are injected into the N-type semiconductor substrate 15 on both outer sides of the high withstand voltage P-type well 16A to form N-type diffusion layers 61 and 62, respectively. In addition, P-type impurity ions (for example, B with a dose amount of, for example, 1 x 10¹³ to 5 x 10¹³ ions/cm²) are injected into the high withstand voltage P-type well 16A near the N-type diffusion layers 61 and 62 to form P-type diffusion layers 51 and 52, respectively. Then, N-type impurity ions (for example, P or As with a dose amount of, for example, 2 x 10¹² to 1 x 10¹³ ions/cm²) are injected into the high withstand voltage P-type well 16A between the P-type diffusion layers 51 and 52 to form an N-type well 17. Then, N-type impurity ions (for example, P or As with a dose amount of, for example, 1 x 10¹⁵ to 7 x 10¹⁵ ions/cm²) are injected into the N-type well 17 to form an N-type diffusion layer 63. This apposes the N-type diffusion layer 61, the P-type diffusion layer 51, the N-type diffusion layer 63, the P-type diffusion layer 52, and the N-type diffusion layer 62 from the right side in the figure, near the substrate surfaces of the N-type semiconductor substrate 15, the high withstand voltage P-type well 16, and the N-type well 17.

Next, an insulating film 40 made of, for example, SiO₂, is formed between the N-type diffusion layer 61 and the P-type diffusion layer 51, between the P-type diffusion layer 51 and the N-type diffusion layer 63, between the N-type diffusion layer 63 and the P-type diffusion layer 52, and between the P-type diffusion layer 52 and the N-type diffusion layer 62 near the substrate surface. Further, bonding wires connect the P-type diffusion layers 51 and 52 to an anode electrode 1 via electrodes 51m and 52m, respectively. In addition, bonding wires connect the N-type diffusion layer 63 to a cathode electrode 2 via an electrode 63m. Through the above steps, the high withstand voltage ESD protection diode 104 is formed.

In the ESD protection diodes 101 to 104 configured as described above, when the voltage potential difference between the P-type diffusion layers 21 to 23, 51, and 52 connected to the anode electrode 1 and the N-type diffusion layers 31, 32, and 63 connected to the cathode electrode 2 becomes equal to or larger than the forward voltage Vf, then the PN junction diodes are turned on in the forward direction, which can discharge the ESD surge. In the high withstand voltage ESD protection diodes 102 and 104, to secure a reverse withstand voltage, the PN junctions are formed between wells with low concentrations (11A and 12)(16A and 17). In the wells with low concentrations (11A and 12)(16A and 17), even when a voltage equal to or higher than the forward voltage Vf is applied thereto, the responsiveness degrades because of the resistance component of the PN junctions, resulting in a problem.

For example, in an application mode in which discharge is performed in an extremely short time such as a charged device model (CDM), responsiveness of the protection element is very important. With respect to an applied pulse such as CDM, a parasitic bipolar transistor has higher responsiveness than a PN diode. This is because while the P-type diffusion layer and the N-type well are forward biased, the parasitic bipolar transistor is also turned on, but the on-resistance Ron is much smaller and better than the diode.

In addition, the bipolar transistor has a characteristic that it can be turned on with injection of a small amount of charge, whereas in the PN diode, a voltage of (V-Vf) simply contributes to discharge. Thus, in particular, at a voltage near the forward voltage Vf, a discharge current of the bipolar transistor becomes larger than that of the diode.

In this manner, it is considered that introduction of the parasitic bipolar transistor having high responsiveness can reduce the overshoot voltage and improve the CDM withstand voltage. In order to improve the responsiveness of the protection element such as the ESD protection diode, the embodiments according to the present invention have a configuration in which a parasitic bipolar transistor is introduced into a PN diode by having a structure of adding a diffusion layer having a conductivity type different from that of a well and connecting the diffusion layer to the anode electrode or the cathode electrode.

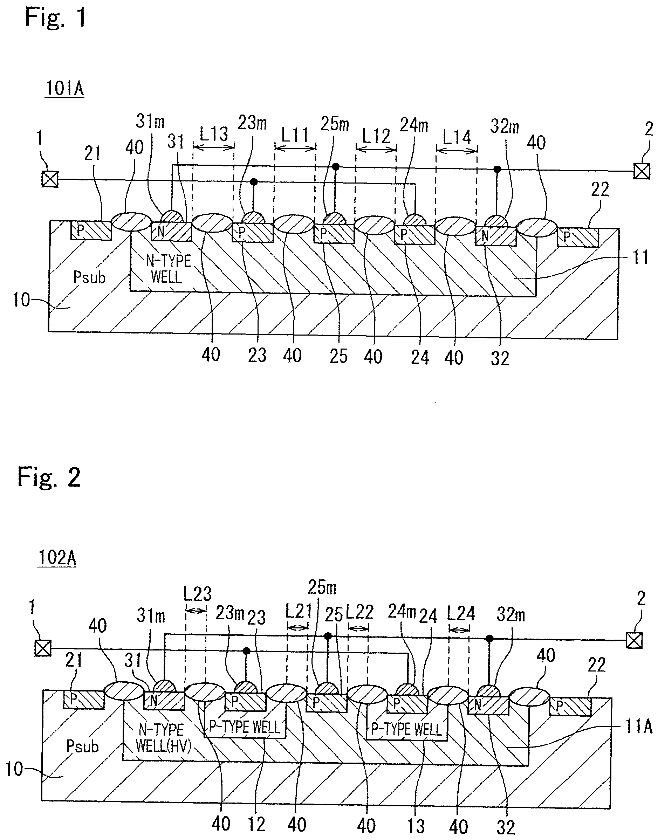

The configuration examples of ESD protection diodes 101 to 104 according to embodiments of the present invention will be described below with reference to Figs. 1 to 4.

### FIRST EMBODIMENT

Fig. 1 is a longitudinal sectional view illustrating a configuration example of an ESD protection diode 101A according to a first embodiment. The ESD protection diode 101A of Fig. 1 is different from the ESD protection diode 101 of Fig. 9 in the following points.
(1) A lateral PNP parasitic bipolar transistor having high responsiveness as compared with that of the prior art has been formed by providing a P-type diffusion layer 25 connected to a cathode electrode 2 while maintaining the structure of PN diodes (23 and 31, 24 and 32) on both ends.
(2) A P-type diffusion layer 24 connected to an anode electrode 1 has been provided for the balance configuration of the semiconductor element. This forms PN diodes with a pair of the P-type diffusion layer 23 and the N-type diffusion layer 31 and a pair of the P-type diffusion layer 24 and the N-type diffusion layer 32 at both ends of an N-type well 11, and configures the lateral PNP parasitic bipolar transistor such that the P-type diffusion layers 23 and 24 connected to the anode electrode 1 are used as emitters, the N-type well 11 is used as a base, and the P-type diffusion layer 25 connected to the cathode electrode 2 is used as a collector.

First of all, a method for forming the ESD protection diode 101A of Fig. 1 and the structure of the ESD protection diode will be described below.

Referring to Fig. 1, N-type impurity ions (for example, P or As with a dose amount of, for example, 2 x 10¹² to 1 x 10¹³ ions/cm²) are injected into a central portion of a P-type semiconductor substrate 10 to form the N-type well 11. Next, P-type impurity ions (for example, B with a dose amount of, for example, 1 x 10¹⁵ to 5 x 10¹⁵ ions/cm²) are injected into the P-type semiconductor substrate 10 on both outer sides of the N-type well 11 to form P-type diffusion layers 21 and 22, respectively. In addition, N-type impurity ions (for example, P or As with a dose amount of, for example, 1 x 10¹⁵ to 7 x 10¹⁵ ions/cm²) are injected into the N-type well 11 near the P-type diffusion layers 21 and 22 to form N-type diffusion layers 31 and 32, respectively. Then, P-type impurity ions (for example, B with a dose amount of, for example, 1 x 10¹⁵ to 5 x 10¹⁵ ions/cm²) are injected into three positions of the N-type well 11 between the N-type diffusion layers 31 and 32 with predetermined intervals to form P-type diffusion layers 23, 25, and 24. This apposes the P-type diffusion layer 21, the N-type diffusion layer 31, the P-type diffusion layers 23, 25, and 24, the N-type diffusion layer 32, and the P-type diffusion layer 22 from the left side in the figure in a lateral direction substantially parallel to the surface of the semiconductor substrate 10, near the substrate surfaces of the P-type semiconductor substrate 10 and the N-type well 11.

Next, an insulating film 40 made of, for example, SiO₂, is formed between the P-type diffusion layer 21 and the N-type diffusion layer 31, between the N-type diffusion layer 31 and the P-type diffusion layer 23, between the P-type diffusion layer 23 and the P-type diffusion layer 25, between the P-type diffusion layer 25 and the P-type diffusion layer 24, between the P-type diffusion layer 24 and the N-type diffusion layer 32, and between the N-type diffusion layer 32 and the P-type diffusion layer 22 near the substrate surface. Further, bonding wires connect the P-type diffusion layers 23 and 24 to the anode electrode 1 via electrodes 23m and 24m, respectively. In addition, bonding wires connect the N-type diffusion layers 31 and 32 and the P-type diffusion layer 25 to the cathode electrode 2 via electrodes 31m, 32m, and 25m, respectively. Through the above steps, the ESD protection diode 101A is formed.

The ESD protection diode 101A configured as described above proposes a novel structure of introducing a lateral PNP parasitic bipolar transistor into a diode structure to improve the responsiveness the diode, and the ESD protection diode has the following two features A and B.

(Feature A) A lateral PNP parasitic bipolar transistor having high responsiveness is formed by connecting the P-type diffusion layer 25 to the cathode electrode 2 while maintaining the PN diodes with the pair (23 and 31) (24 and 32) of the P-type diffusion layer and the N-type diffusion layer connected to the anode 1. In this case, the lateral PNP parasitic bipolar transistor has a base of the N-type well 11, emitters of the P-type diffusion layers 23 and 24 connected to the anode electrode 1, and a collector of the P-type diffusion layer 25 connected to the cathode electrode 2.

(Feature B) Two PN diodes are formed at both ends of the N-type well 11, and a lateral PNP parasitic bipolar transistor is formed at a central portion of the N-type well 11 sandwiched between the two PN diodes.

The configuration with the above features A and B enables a structure in which distances L11 and L12 between the two pairs of P-type diffusion layers (23 and 25) (24 and 25) are the minimum distance, and enables a structure in which distances L13 and L14 between the two pairs of P-type diffusion layer/N-type diffusion layer (31 and 23) (32 and 22) are the minimum distance. The purpose of minimizing the distances L11 and L12 is to increase a current amplification factor hfe of the bipolar transistor and to increase the withstand voltage by making the lateral PNP parasitic bipolar transistor have the shortest base. In addition, the purpose of minimizing the distances L13 and L14 is to allow the PN diodes to operate normally and to increase the withstand voltage. It is clear from the evaluation results of the implementation examples described later that the CDM withstand voltage decreases when each PN diode has a long path length instead of the minimum distance. According to the prototype of the inventors of the present invention, the distances L11 to L14 are preferably minimum distances that are set based on a predetermined device withstand voltage, and are, for example, 1 to 5 µm.

As described above, the ESD protection diode 101 according to the first embodiment has a configuration in which a parasitic bipolar transistor is introduced into a PN diode by having the structure of adding the P-type diffusion layer 25 having a conductivity type different from that of the N-type well 11 and connecting the P-type diffusion layer 25 to the cathode electrode 2 to improve the responsiveness of the protection element such as the ESD protection diode. That is, the CDM withstand voltage can be particularly improved by improving the responsiveness of the ESD protection diode. It is considered that introduction of the PNP parasitic bipolar transistor having high responsiveness as compared with that of the prior art in this manner can reduce the overshoot voltage and improve the CDM withstand voltage.

### SECOND EMBODIMENT

Fig. 2 is a longitudinal sectional view illustrating a configuration example of a high withstand voltage ESD protection diode 102A according to a second embodiment. The ESD protection diode 102A of Fig. 2 is different from the ESD protection diode 102 of Fig. 10 in the following points.
(1) A lateral PNP parasitic bipolar transistor having high responsiveness as compared with that of the prior art has been formed by providing a P-type diffusion layer 25 connected to a cathode electrode 2 while maintaining the structure of PN diodes (23 and 31, 24 and 32) on both ends.
(2) A P-type diffusion layer 24 connected to an anode electrode 1 has been provided for the balance configuration of the semiconductor element. This forms PN diodes with a pair of the P-type diffusion layer 23 and the N-type diffusion layer 31 and a pair of the P-type diffusion layer 24 and the N-type diffusion layer 32 at both ends of a high withstand voltage N-type well 11A, and configures the lateral PNP parasitic bipolar transistor such that the P-type diffusion layers 23 and 24 connected to the anode electrode 1 are used as emitters, the high withstand voltage N-type well 11A is used as a base, and the P-type diffusion layer 25 connected to the cathode electrode 2 is used as a collector.

First of all, a method for forming the ESD protection diode 102A of Fig. 2 and the structure of the ESD protection diode will be described below.

Referring to Fig. 1, N-type impurity ions (for example, P or As with a dose amount of, for example, 5 x 12¹² to 1 x 10¹³ ions/cm²) are injected into a central portion of a P-type semiconductor substrate 10 to form a high withstand voltage N-type well 11A. Next, P-type impurity ions (for example, B with a dose amount of, for example, 1 x 10¹⁵ to 5 x 10¹⁵ ions/cm²) are injected into the P-type semiconductor substrate 10 on both outer sides of the N-type well 11A to form P-type diffusion layers 21 and 22, respectively. In addition, N-type impurity ions (for example, P or As with a dose amount of, for example, 1 x 10¹⁵ to 7 x 10¹⁵ ions/cm²) are injected into the N-type well 11A near the P-type diffusion layers 21 and 22 to form N-type diffusion layers 31 and 32, respectively. Then, P-type impurity ions (for example, B with a dose amount of, for example, 1 x 10¹³ to 5 x 10¹³ ions/cm²) are injected into two positions on the outer sides among three positions of the N-type well 11A between the N-type diffusion layers 31 and 32 with predetermined intervals to form P-type wells 12 and 13. Then, P-type impurity ions (for example, B with a dose amount of, for example, 1 x 10¹⁵ to 5 x 10¹⁵ ions/cm²) are injected into three positions (two positions on the outer sides are the formation positions for the P-type wells 12 and 13) of the N-type well 11A between the N-type diffusion layers 31 and 32 with predetermined intervals to form P-type diffusion layers 23, 25, and 24. This apposes the P-type diffusion layer 21, the N-type diffusion layer 31, the P-type diffusion layers 23, 25, and 24, the N-type diffusion layer 32, and the P-type diffusion layer 22 from the left side in the figure in a lateral direction substantially parallel to the surface of the semiconductor substrate 10, near the substrate surfaces of the P-type semiconductor substrate 10 and the N-type well 11A.

Next, an insulating film 40 made of, for example, SiO₂, is formed between the P-type diffusion layer 21 and the N-type diffusion layer 31, between the N-type diffusion layer 31 and the P-type diffusion layer 23, between the P-type diffusion layer 23 and the P-type diffusion layer 25, between the P-type diffusion layer 25 and the P-type diffusion layer 24, between the P-type diffusion layer 24 and the N-type diffusion layer 32, and between the N-type diffusion layer 32 and the P-type diffusion layer 22 near the substrate surface. Further, bonding wires connect the P-type diffusion layers 23 and 24 to the anode electrode 1 via electrodes 23m and 24m, respectively. In addition, bonding wires connect the N-type diffusion layers 31 and 32 and the P-type diffusion layer 25 to the cathode electrode 2 via electrodes 31m, 32m, and 25m, respectively. Through the above steps, the ESD protection diode 102A is formed.

The ESD protection diode 102A configured as described above, having a novel structure in which a lateral PNP parasitic bipolar transistor is introduced into a diode structure and having the same two features A and B as in the first embodiment, in which the high withstand voltage N-type well 11A and the P-type wells 12 and 13 are formed to improve the responsiveness of the diode, can increase the withstand voltage of the entire device of the ESD protection diode 102A as compared with that of the ESD protection diode 101A of the first embodiment.

The configuration with the above features A and B enables a structure in which distances L21 and L22 between the two pairs of P-type diffusion layers (23 and 25) (24 and 25) are the minimum distance, and enables a structure in which distances L23 and L24 between the two pairs of P-type diffusion layer/N-type diffusion layer (31 and 23) (32 and 22) are the minimum distance. The purpose of minimizing the distances L21 and L22 is to increase a current amplification factor hfe of the bipolar transistor and to increase the withstand voltage by making the lateral PNP parasitic bipolar transistor have the shortest base. In addition, the purpose of minimizing the distances L23 and L24 is to allow the PN diodes to operate normally and to increase the withstand voltage. It is clear from the evaluation results of the implementation examples described later that the CDM withstand voltage decreases when each PN diode has a long path length instead of the minimum distance. According to the prototype of the inventors of the present invention, the distances L21 to L24 are preferably minimum distances that are set based on a predetermined device withstand voltage, and are, for example, 10 to 15 µm.

As described above, the ESD protection diode 102A according to the second embodiment has a configuration in which a PNP parasitic bipolar transistor is introduced into a PN diode by having the structure of adding the P-type diffusion layer 25 having a conductivity type different from that of the N-type well 11A and connecting the P-type diffusion layer 25 to the cathode electrode 2 to improve the responsiveness of the protection element such as the ESD protection diode. That is, the CDM withstand voltage can be particularly improved by improving the responsiveness of the ESD protection diode. It is considered that introduction of the PNP parasitic bipolar transistor having high responsiveness as compared with that of the prior art in this manner can reduce the overshoot voltage and improve the CDM withstand voltage.

### THIRD EMBODIMENT

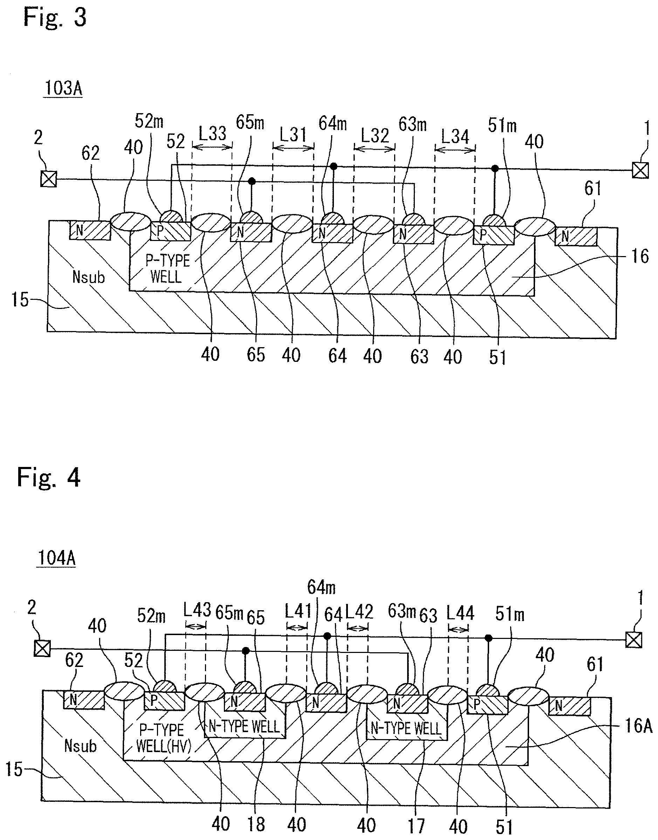

Fig. 3 is a longitudinal sectional view illustrating a configuration example of an ESD protection diode 103A according to a third embodiment. The ESD protection diode 103A of Fig. 3 is different from the ESD protection diode 103 of Fig. 11 in the following points.
(1) A lateral NPN parasitic bipolar transistor having high responsiveness as compared with that of the prior art has been formed by providing an N-type diffusion layer 64 connected to an anode electrode 1 while maintaining the structure of PN diodes (52 and 65, 51 and 63) on both ends.
(2) An N-type diffusion layer 65 connected to a cathode electrode 2 has been provided for the balance configuration of the semiconductor element. This forms PN diodes with a pair of the P-type diffusion layer 51 and the N-type diffusion layer 63 and a pair of the P-type diffusion layer 52 and the N-type diffusion layer 65 at both ends of a P-type well 16, and configures the lateral NPN parasitic bipolar transistor such that the N-type diffusion layer 64 connected to the anode electrode 1 is used as a collector, the P-type well 16 is used as a base, and the N-type diffusion layers 63 and 65 connected to the cathode electrode 2 are used as emitters.

First of all, a method for forming the ESD protection diode 103A of Fig. 3 and the structure of the ESD protection diode will be described below.

Referring to Fig. 3, P-type impurity ions (for example, B with a dose amount of, for example, 1 x 10¹³ to 5 x 10¹³ ions/cm²) are injected into a central portion of an N-type semiconductor substrate 15 to form a P-type well 16. Next, N-type impurity ions (for example, P or As with a dose amount of, for example, 1 x 10¹⁵ to 7 x 10¹⁵ ions/cm²) are injected into the N-type semiconductor substrate 15 on both outer sides of the P-type well 16 to form N-type diffusion layers 61 and 62, respectively. In addition, P-type impurity ions (for example, B with a dose amount of, for example, 1 x 10¹³ to 5 x 10¹³ ions/cm²) are injected into the P-type well 16 near the N-type diffusion layers 61 and 62 to form P-type diffusion layers 51 and 52, respectively. Then, N-type impurity ions (for example, P or As with a dose amount of, for example, 1 x 10¹⁵ to 7 x 10¹⁵ ions/cm²) are injected into three position of the P-type well 16 between the P-type diffusion layers 51 and 52 at predetermined intervals to form N-type diffusion layers 63, 64, and 65. This apposes the N-type diffusion layer 61, the P-type diffusion layer 51, the N-type diffusion layers 63, 64, and 65, the P-type diffusion layer 52, and the N-type diffusion layer 62 from the right side in the figure in a lateral direction substantially parallel to the surface of the semiconductor substrate 10, near the substrate surfaces of the N-type semiconductor substrate 15 and the P-type well 16.

Next, an insulating film 40 made of, for example, SiO₂, is formed between the N-type diffusion layer 61 and the P-type diffusion layer 51, between the P-type diffusion layer 51 and the N-type diffusion layer 63, between the N-type diffusion layer 63 and the N-type diffusion layer 64, between the N-type diffusion layer 64 and the N-type diffusion layer 65, between the N-type diffusion layer 65 and the P-type diffusion layer 52, and between the P-type diffusion layer 52 and the N-type diffusion layer 62 near the substrate surface. Further, bonding wires connect the P-type diffusion layers 51 and 52 and the N-type diffusion layer 64 to the anode electrode 1 via electrodes 51m, 52m, and 64m, respectively. In addition, bonding wires connect the N-type diffusion layers 63 and 65 to the cathode electrode 2 via electrodes 63m and 65m, respectively. Through the above steps, the ESD protection diode 103A is formed.

The ESD protection diode 103A configured as described above proposes a novel structure of introducing a lateral NPN parasitic bipolar transistor into a diode structure to improve the responsiveness of the diode, and the ESD protection diode has the following two features C and D.

(Feature C) A lateral NPN parasitic bipolar transistor having high responsiveness is formed by connecting the N-type diffusion layer 64 to the anode electrode 1 while maintaining the PN diodes with the pair (51 and 63) (52 and 65) of the P-type diffusion layer and the N-type diffusion layer connected to the anode 1. In this case, the lateral NPN parasitic bipolar transistor has a base of the P-type well 16, a collector of the N-type diffusion layer 64 connected to the anode electrode 1, and emitters of the P-type diffusion layers 63 and 65 connected to the cathode electrode 2.

(Feature D) Two PN diodes are formed at both ends of the P-type well 16, and a lateral NPN parasitic bipolar transistor is formed at a central portion of the P-type well 16 sandwiched between the two PN diodes.

The configuration with the above features C and D enables a structure in which distances L31 and L32 between the two pairs of N-type diffusion layers (64 and 65) (63 and 64) are the minimum distance, and enables a structure in which distances L34 and L33 between the two pairs of P-type diffusion layer/N-type diffusion layer (51 and 63) (52 and 65) are the minimum distance. The purpose of minimizing the distances L31 and L32 is to increase a current amplification factor hfe of the bipolar transistor and to increase the withstand voltage by making the lateral NPN parasitic bipolar transistor have the shortest base. In addition, the purpose of minimizing the distances L33 and L34 is to allow the PN diodes to operate normally and to increase the withstand voltage. It is clear from the evaluation results of the implementation examples described later that the CDM withstand voltage decreases when each PN diode has a long path length instead of the minimum distance. According to the prototype of the inventors of the present invention, the distances L31 to L34 are preferably minimum distances that are set based on a predetermined device withstand voltage, and are, for example, 1 to 5 µm.

As described above, the ESD protection diode 103A according to the third embodiment has a configuration in which a parasitic bipolar transistor is introduced into a PN diode by having the structure of adding the N-type diffusion layer 64 having a conductivity type different from that of the P-type well 16 and connecting the N-type diffusion layer 64 to the anode electrode 1 to improve the responsiveness of the protection element such as the ESD protection diode. That is, the CDM withstand voltage can be particularly improved by improving the responsiveness of the ESD protection diode. It is considered that introduction of the NPN parasitic bipolar transistor having high responsiveness as compared with that of the prior art in this manner can reduce the overshoot voltage and improve the CDM withstand voltage.

### FOURTH EMBODIMENT

Fig. 4 is a longitudinal sectional view illustrating a configuration example of a high withstand voltage ESD protection diode 104A according to a fourth embodiment. The ESD protection diode 104A of Fig. 4 is different from the ESD protection diode 104 of Fig. 12 in the following points.
(1) A lateral NPN parasitic bipolar transistor having high responsiveness as compared with that of the prior art has been formed by providing an N-type diffusion layer 64 connected to an anode electrode 1 while maintaining the structure of PN diodes (51 and 63, 52 and 65) on both ends.
(2) An N-type diffusion layer 65 connected to an anode electrode 1 has been provided for the balance configuration of the semiconductor element. This forms PN diodes with a pair of the P-type diffusion layer 51 and the N-type diffusion layer 63 and a pair of the P-type diffusion layer 52 and the N-type diffusion layer 65 at both ends of a high withstand voltage P-type well 16A, and configures the lateral NPN parasitic bipolar transistor such that the N-type diffusion layer 64 connected to the anode electrode 1 is used as an emitter, the high withstand voltage P-type well 16A is used as a base, and the N-type diffusion layers 63 and 65 connected to the cathode electrode 2 are used as collectors.

First of all, a method for forming the ESD protection diode 104A of Fig. 4 and the structure of the ESD protection diode will be described below.

Referring to Fig. 4, P-type impurity ions (for example, B with a dose amount of, for example, 2 x 10¹³ to 1 x 10¹⁴ ions/cm²) are injected into a central portion of an N-type semiconductor substrate 15 to form a high withstand voltage P-type well 16A. Next, N-type impurity ions (for example, P or As with a dose amount of, for example, 1 x 10¹⁵ to 7 x 10¹⁵ ions/cm²) are injected into the N-type semiconductor substrate 15 on both outer sides of the high withstand voltage P-type well 16A to form N-type diffusion layers 61 and 62, respectively. In addition, P-type impurity ions (for example, B with a dose amount of, for example, 1 x 10¹³ to 5 x 10¹³ ions/cm²) are injected into the high withstand voltage P-type well 16A near the N-type diffusion layers 61 and 62 to form P-type diffusion layers 51 and 52, respectively. Then, N-type impurity ions (for example, P or As with a dose amount of, for example, 2 x 10¹² to 1 x 10¹³ ions/cm²) are injected into two positions on the outer sides among three positions of the high withstand voltage P-type well 16A between the P-type diffusion layers 51 and 52 with predetermined intervals to form N-type wells 17 and 18, respectively. Then, N-type impurity ions (for example, P or As with a dose amount of, for example, 1 x 10¹⁵ to 7 x 10¹⁵ ions/cm²) are injected into three positions (two positions on the outer sides are the formation positions for the high withstand voltage P-type well 16A) between the P-type diffusion layers 51 and 52 with predetermined intervals to form N-type diffusion layers 63, 64, and 65. This apposes the N-type diffusion layer 61, the P-type diffusion layer 51, the N-type diffusion layers 63, 64, and 65, the P-type diffusion layer 52, and the N-type diffusion layer 62 from the right side in the figure in a lateral direction substantially parallel to the surface of the semiconductor substrate 10, near the substrate surfaces of the N-type semiconductor substrate 15 and the high withstand voltage P-type well 16A.

Next, an insulating film 40 made of, for example, SiO₂, is formed between the N-type diffusion layer 61 and the P-type diffusion layer 51, between the P-type diffusion layer 51 and the N-type diffusion layer 63, between the N-type diffusion layer 63 and the N-type diffusion layer 64, between the N-type diffusion layer 64 and the N-type diffusion layer 65, between the N-type diffusion layer 65 and the P-type diffusion layer 52, and between the P-type diffusion layer 52 and the N-type diffusion layer 62 near the substrate surface. Further, bonding wires connect the P-type diffusion layers 51 and 52 and the N-type diffusion layer 64 to the anode electrode 1 via electrodes 51m, 52m, and 64m, respectively. In addition, bonding wires connect the N-type diffusion layers 63 and 65 to the cathode electrode 2 via electrodes 63m and 65m, respectively. Through the above steps, the ESD protection diode 104A is formed.

The ESD protection diode 104A is configured as described above, having a novel structure in which a lateral NPN parasitic bipolar transistor is introduced into a diode structure and having the same two features C and D as in the third embodiment, in which the high withstand voltage P-type well 16A and the N-type wells 17 and 18 are formed to improve the responsiveness of the diode. Then the ESD protection diode 104A can increase the withstand voltage of the entire device of the ESD protection diode 104B as compared with that of the ESD protection diode 103A of the third embodiment.

The configuration with the above features C and D enables a structure in which distances L41 and L42 between the two pairs of N-type diffusion layers (64 and 65) (63 and 64) are the minimum distance, and enables a structure in which distances L44 and L43 between the two pairs of P-type diffusion layer/N-type diffusion layer (51 and 63) (52 and 62) are the minimum distance. The purpose of minimizing the distances L41 and L42 is to increase a current amplification factor hfe of the bipolar transistor and to increase the withstand voltage by making the lateral NPN parasitic bipolar transistor have the shortest base. In addition, the purpose of minimizing the distances L43 and L44 is to allow the PN diodes to operate normally and to increase the withstand voltage. It is clear from the evaluation results of the implementation examples described later that the CDM withstand voltage decreases when each PN diode has a long path length instead of the minimum distance. According to the prototype of the inventors of the present invention, the distances L41 to L44 are preferably minimum distances that are set based on a predetermined device withstand voltage, and are, for example, 10 to 15 µm.

The ESD protection diode 104A configured as described above has a configuration in which a parasitic bipolar transistor is introduced into a PN diode by having the structure of adding the N-type diffusion layer 64 having a conductivity type different from that of the P-type well 16A and connecting the N-type diffusion layer 64 to the anode electrode 1 to improve the responsiveness of the protection element such as the ESD protection diode. That is, the CDM withstand voltage can be particularly improved by improving the responsiveness of the ESD protection diode. It is considered that introduction of the NPN parasitic bipolar transistor having high responsiveness as compared with that of the prior art in this manner can reduce the overshoot voltage and improve the CDM withstand voltage.

### IMPLEMENTATION EXAMPLES

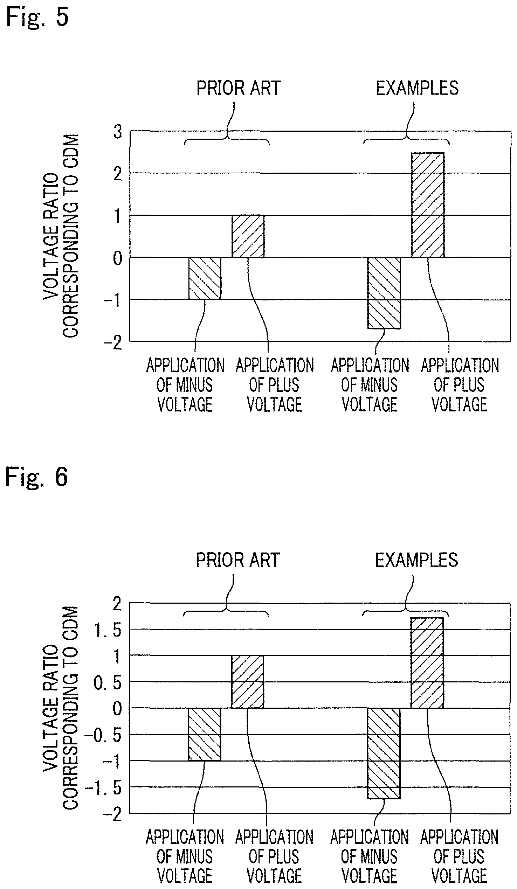

Fig. 5 is a graph illustrating a voltage ratio with respect to CDM which is a JEITA-standard D(Direct)-CDM test result of a conventional example and the ESD protection diode 101A according to the first embodiment mounted in a QFN0808-type package manufactured by the applicant according to Implementation Example 1. Fig. 6 is a graph illustrating a voltage ratio with respect to CDM which is a JEDEC-standard FI(Field-Induced)-CDM test result of a conventional example and the ESD protection diode 101A according to the first embodiment mounted in a QFN0808-type package manufactured by the applicant according to Implementation Example 2. Fig. 7 is a graph illustrating a voltage ratio with respect to CDM which is a JEDEC-standard FI(Field-Induced)-CDM test result of a conventional example and the ESD protection diode 101A according to the first embodiment mounted in an HSOP18-type package manufactured by the applicant according to Implementation Example 3. In this case, the reference value is a voltage value of the ESD protection diode according to the conventional example.

Figs. 5 to 7 show how much the CDM withstand voltage has improved in the device structure according to the embodiment with the voltage ratio of the CDM withstand voltage with respect to the reference value according to the conventional example. As is clear from Figs. 5 to 7, it was possible to indicate that the CDM withstand voltage has improved in all the implementation examples.

### OTHER MODIFIED EMBODIMENTS

In the above embodiments, the embodiments of Figs. 1 to 4 have been described, but the present invention is not limited to these embodiments. The present invention can take a configuration of, in an ESD protection diode including two pairs of PN diodes each configured by a P-type diffusion layer and an N-type diffusion layer in a semiconductor substrate, including a lateral bipolar transistor including a diffusion layer connected to a cathode electrode or an anode electrode, the diffusion layer having a polarity different from that of the terminal, the P-type diffusion layer, and the N-type diffusion layer provided at a position of the semiconductor substrate sandwiched between the two pairs of PN diodes.

### DIFFERENCE FROM PATENT DOCUMENT 1

Hereinafter, differences from Patent Document 1 will be described.

Patent Document 1 discloses, to protect a gate oxide film from overvoltage caused by an ESD surge (in particular, a CDM), a configuration of using a low-capacity gate diode having excellent conductance per unit length and turn-on speed, the low-capacity gate diode not adversely affecting performance of a circuit to be protected. In addition, Patent Document 1 discloses a method for reducing junction capacitance, resulting in a problem unique to a gate diode. The present invention is certainly similar to the present invention in that the present invention is a protection element for CDM.

However, the invention according to Patent Document 1 takes a measure of blocking a pocket implant with a pocket implant mask to reduce the junction capacitance in the diode, and it is considered that the existing process flow needs to be changed for the technical application. In addition, the use of the gate diode has caused a problem of load capacitance. That is, without the use of a gate diode, the load capacitance is not particularly problematic. On the other hand, in the embodiments according to the present invention, an ESD protection diode having high responsiveness has been produced without changing the process flow and without using a gate diode.

### INDUSTRIAL APPLICABILITY

As described in detail above, to improve the responsiveness of the protection element such as the ESD protection diode, the ESD protection diode according to the present invention has a configuration in which a parasitic bipolar transistor is introduced into a PN diode by having a structure of adding a diffusion layer having a conductivity type different from that of a well and connecting the diffusion layer to the anode electrode or the cathode electrode. That is, the CDM withstand voltage can be particularly improved by improving the responsiveness of the ESD protection diode. It is considered that introduction of the PNP parasitic bipolar transistor having high responsiveness as compared with that of the prior art in this manner can reduce the overshoot voltage and improve the CDM withstand voltage.

### REFERENCE SIGNS LIST

1 Anode electrode
2 Cathode electrode
10 P-type semiconductor substrate
11 N-type well
11A High withstand voltage N-type well
12, 13 P-type well
15 N-type semiconductor substrate
16 P-type well
16A High withstand voltage P-type well
17 and 18 N-type well
21 to 25 P-type diffusion layer
23m to 25m Electrode
31 to 32 N-type diffusion layer
31m to 32m Electrode
40 Insulating film
51 to 52 P-type diffusion layer
51m to 52m Electrode
61 to 65 N-type diffusion layer
63m to 65m Electrode
100 Internal circuit
101 to 104 and 101A to 104A ESD protection diode
T1 to T3 Terminal

## Claims

1. An ESD protection diode comprising two pairs of PN diodes in a semiconductor substrate, each of the two pairs of PN including a P-type diffusion layer and an N-type diffusion layer,
wherein the ESD protection diode further comprises a lateral bipolar transistor at a position of the semiconductor substrate sandwiched between the two pairs of PN diodes, and
wherein the lateral bipolar transistor includes:
a diffusion layer connected to a cathode electrode or an anode electrode of the ESD protection diode, the diffusion layer having a polarity different from a polarity of the cathode electrode or the anode electrode;
the P-type diffusion layer; and
the N-type diffusion layer.

2. The ESD protection diode as claimed in claim 1,
wherein the two pairs of PN diodes include:
a first PN diode including a first P-type diffusion layer and a first N-type diffusion layer; and
a second PN diode including a second P-type diffusion layer and a second N-type diffusion layer, and
wherein the lateral bipolar transistor includes:
the first and second P-type diffusion layers connected to the anode electrode;
a third P-type diffusion layer formed at a position between the first and second P-type diffusion layers and connected to the cathode electrode; and
the first and second N-type diffusion layers formed in an N-type well in the semiconductor substrate.

3. The ESD protection diode as claimed in claim 2,
wherein the first, second, and third P-type diffusion layers are formed in the N-type well in the semiconductor substrate,
wherein the first and second P-type diffusion layers are emitters of the lateral bipolar transistor,
wherein the N-type well is a base of the lateral bipolar transistor, and
wherein the third P-type diffusion layer is a collector of the lateral bipolar transistor.

4. The ESD protection diode as claimed in claim 3, further comprising:
a fourth P-type diffusion layer formed on the semiconductor substrate on an outer side of the first N-type diffusion layer opposite to the first P-type diffusion layer, the fourth P-type diffusion layer being connected to the anode electrode; and
a fifth P-type diffusion layer formed on the semiconductor substrate on an outer side of the second N-type diffusion layer opposite to the second P-type diffusion layer, the fifth P-type diffusion layer being connected to the anode electrode.

5. The ESD protection diode as claimed in claim 2,
wherein the first and second P-type diffusion layers are formed in a P-type well in the semiconductor substrate,
wherein the third P-type diffusion layer is formed in the N-type well in the semiconductor substrate,
wherein the first and second P-type diffusion layers are emitters of the lateral bipolar transistor,
wherein the N-type well is a base of the lateral bipolar transistor, and
wherein the third P-type diffusion layer is a collector of the lateral bipolar transistor.

6. The ESD protection diode as claimed in any one of claims 3 to 5,
wherein a distance between each of the emitters and the collector of the lateral bipolar transistor is set to a minimum distance, that is set in accordance with a predetermined device withstand voltage.

7. The ESD protection diode as claimed in any one of claims 3 to 5,
wherein each of a distance between the first P-type diffusion layer and the first N-type diffusion layer and a distance between the second P-type diffusion layer and the second N-type diffusion layer is set to a minimum distance, that is set in accordance with a predetermined device withstand voltage.

8. The ESD protection diode as claimed in claim 1,
wherein the two pairs of PN diodes include:
a first PN diode including a first P-type diffusion layer and a first N-type diffusion layer, and
a second PN diode including a second P-type diffusion layer and a second N-type diffusion layer, and
wherein the lateral bipolar transistor includes:
the first and second N-type diffusion layers connected to the cathode electrode,
a third N-type diffusion layer formed at a position between the first and second N-type diffusion layers, the third N-type diffusion layer being connected to the anode electrode, and
the first and second P-type diffusion layers formed in a P-type well in the semiconductor substrate.

9. The ESD protection diode as claimed in claim 8,
wherein the first, second, and third N-type diffusion layers are formed in the P-type well in the semiconductor substrate,
wherein the first and second N-type diffusion layers are emitters of the lateral bipolar transistor,
wherein the P-type well is a base of the lateral bipolar transistor, and
wherein the third N-type diffusion layer is a collector of the lateral bipolar transistor.

10. The ESD protection diode as claimed in claim 9, further comprising:
a fourth N-type diffusion layer formed on the semiconductor substrate on an outer side of the first P-type diffusion layer opposite to the first N-type diffusion layer, the fourth N-type diffusion layer being connected to the cathode electrode; and
a fifth N-type diffusion layer formed on the semiconductor substrate on an outer side of the second P-type diffusion layer opposite to the second N-type diffusion layer, the fifth N-type diffusion layer being connected to the cathode electrode.

11. The ESD protection diode as claimed in claim 8,
wherein the first and second N-type diffusion layers are formed in an N-type well in the semiconductor substrate,
wherein the third N-type diffusion layer is formed in the P-type well in the semiconductor substrate,
wherein the first and second N-type diffusion layers are emitters of the lateral bipolar transistor,
wherein the P-type well is a base of the lateral bipolar transistor, and
wherein the third N-type diffusion layer is a collector of the lateral bipolar transistor.

12. The ESD protection diode as claimed in any one of claims 9 to 11,
wherein a distance between each of the emitters and the collector of the lateral bipolar transistor is set to a minimum distance, that is set in accordance with a predetermined device withstand voltage.

13. The ESD protection diode as claimed in any one of claims 9 to 11,
wherein each of a distance between the first P-type diffusion layer and the first N-type diffusion layer and a distance between the second P-type diffusion layer and the second N-type diffusion layer is set to a minimum distance, that is set in accordance with a predetermined device withstand voltage.

14. A structure of an ESD protection diode, the ESD protection diode comprising two pairs of PN diodes in a semiconductor substrate, each of the two pairs of PN including a P-type diffusion layer and an N-type diffusion layer,
wherein the ESD protection diode further comprises a lateral bipolar transistor at a position of the semiconductor substrate sandwiched between the two pairs of PN diodes, and
wherein the lateral bipolar transistor includes:
a diffusion layer connected to a cathode electrode or an anode electrode of the ESD protection diode, the diffusion layer having a polarity different from a polarity of the cathode electrode or the anode electrode;
the P-type diffusion layer; and
the N-type diffusion layer.

15. The structure of the ESD protection diode as claimed in claim 14,
wherein the two pairs of PN diodes include:
a first PN diode including a first P-type diffusion layer and a first N-type diffusion layer; and
a second PN diode including a second P-type diffusion layer and a second N-type diffusion layer,
wherein the lateral bipolar transistor includes:
the first and second P-type diffusion layers connected to the anode electrode;
a third P-type diffusion layer formed at a position between the first and second P-type diffusion layers, the third P-type diffusion layer being connected to the cathode electrode, and
the first and second N-type diffusion layers formed in an N-type well in the semiconductor substrate.

16. The structure of an ESD protection diode as claimed in claim 14,
wherein the two pairs of PN diodes include:
a first PN diode including a first P-type diffusion layer and a first N-type diffusion layer, and
a second PN diode including a second P-type diffusion layer and a second N-type diffusion layer, and
wherein the lateral bipolar transistor includes:
the first and second N-type diffusion layers connected to the cathode electrode;
a third N-type diffusion layer formed at a position between the first and second N-type diffusion layers, the third N-type diffusion layer being connected to the anode electrode; and
the first and second P-type diffusion layers formed in a P-type well in the semiconductor substrate.
